**Europäisches Patentamt**

(19) **European Patent Office**

**Office européen des brevets**

(11) Veröffentlichungsnummer: **0 025 181**
**B1**

# (12) EUROPÄISCHE PATENTSCHRIFT

(45) Veröffentlichungstag der Patentschrift:
28.09.83

(21) Anmeldenummer: **80105078.2**

(22) Anmeldetag: **27.08.80**

(51) Int. Cl.³: **G 06 F 11/22, G 01 R 31/02**

(54) Schaltungsanordnung zur rechnergestützten Durchgangsprüfung der in einer Steuerung befindlichen Ausgangselemente, deren Installation und deren Treiber.

(30) Priorität: **04.09.79 DE 2935585**

(43) Veröffentlichungstag der Anmeldung:
**18.03.81 Patentblatt 81/11**

(45) Bekanntmachung des Hinweises auf die Patenterteilung:
**28.09.83 Patentblatt 83/39**

(84) Benannte Vertragsstaaten:
**FR GB IT**

(56) Entgegenhaltungen:
**DD-A-59 335**
**DD-A-120 719**
**DE-A-1 466 552**
**DE-A-1 919 577**
**DE-A-2 525 484**
**DE-A-2 743 538**
**DE-A-2 749 888**
**DE-A-2 813 418**
**DE-B-1 616 386**
**DE-B-1 791 064**
**DE-B-1 947 569**
**US-A-2 947 943**
**IBM Technical Disclosure Bulletin, Vol. 21, No. 1, Juin 1978, S. 115—117**

(73) Patentinhaber: **DÜRKOPPWERKE GMBH,**
**Nikolaus-Dürkopp-Strasse 10, D-4800 Bielefeld 1 (DE)**

(72) Erfinder: **Plassmeier, Horst, Kantstrasse 9,**
**D-4900 Herford (DE)**

BUNDESDRUCKEREI BERLIN

Schaltungsanordnung zur rechnergestützten Durchgangsprüfung der in einer Steuerung
befindlichen Ausgangselemente, deren Installation und deren Treiber

Die Erfindung bezieht sich auf eine Schaltungsanordnung zur rechnergestützten Durchgangsprüfung der in einer Steuerung befindlichen Ausgangselemente (Stellglieder), deren Installation und deren Treiber.

Maschinen mit hohem Mechanisierungs- bzw. Automatisierungsgrad, z. B. automatisierte Nähanlagen, haben heute sehr aufwendige und komplizierte Steuerungen, die u. a. aus einer großen Anzahl von Ausgangselementen (Stellglieder) wie Magnetventile, Stellmagnete, Heizwicklungen und Motoren bestehen. Bei der Behebung von Funktionsstörungen in solchen Anlagen ist sehr häufig eine Durchgangsprüfung der in der Steuerung enthaltenen Ausgangselemente einschließlich deren Installation und deren Treiber erforderlich, um den Bereich (Mechanik oder Elektrik) zu ermitteln, in dem der Fehler zu suchen ist.

Es ist eine Schaltungsanordnung zur mit Gleichspannung durchführbaren Funktionsprüfung mehrerer in einer Steuerung enthaltener, nacheinander zu prüfender Halbleitertreiber gemäß dem Oberbegriff des Anspruches 1 bekannt (DE-A1-2 525 484), bei der jeder einzelne Treiber durch eine eigene, aus Widerständen, einer Diode und einem Schmitt-Trigger bestehende Schaltung so kurzzeitig überwacht wird, daß er mechanisch nicht reagieren kann. Der Trigger wertet die Kollektorspannung der Treibertransistoren aus und ermöglicht somit die Aussage, ob am jeweiligen Kollektor eine hohe oder eine niedrige Spannung anliegt. Somit liegt eine Spannungsmessung vor, mittels der auf die Funktion des jeweiligen Treibers zurückgeschlossen wird. Durch den hier besprochenen Trigger kann nicht erkannt werden, ob in der dem Treiber nachgeschalteten Funktionseinheit Strom fließt. Die aus den Widerständen, der Diode und dem Trigger bestehende Schaltung ist deshalb nicht in der Lage, eine Aussage über mögliche Unterbrechungen im den Treiber nachgeschalteten Lastkreis zu machen.

Der Erfindung liegt die Aufgabe zugrunde, jeden in einer Steuerung enthaltenen Lastkreis, der aus einem Ausgangselement, seiner Installation und seinem vorgeschalteten Treiber besteht, mittels einer zentralen, für die Durchgangsprüfung sämtlicher in der Steuerung vorhandener Lastkreise zuständigen Meßschaltung durch Überprüfung des Stromflusses im angesteuerten Lastkreis auf Durchgang zu prüfen, wobei keine Eingriffe durch Auftrennen der Leitungsführung in den Lastkreisen vorzunehmen sind.

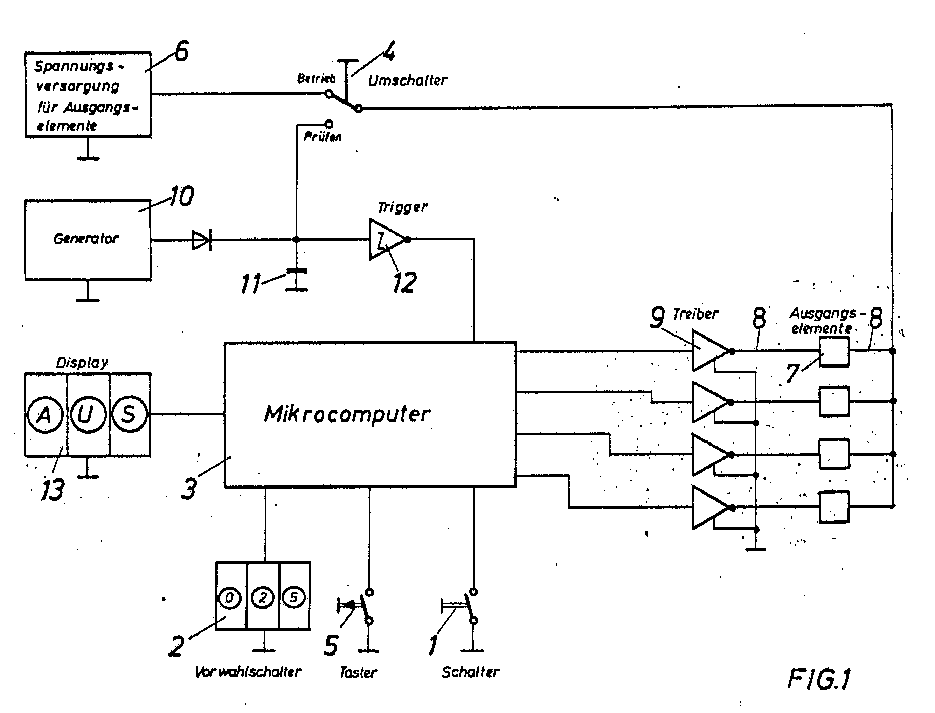

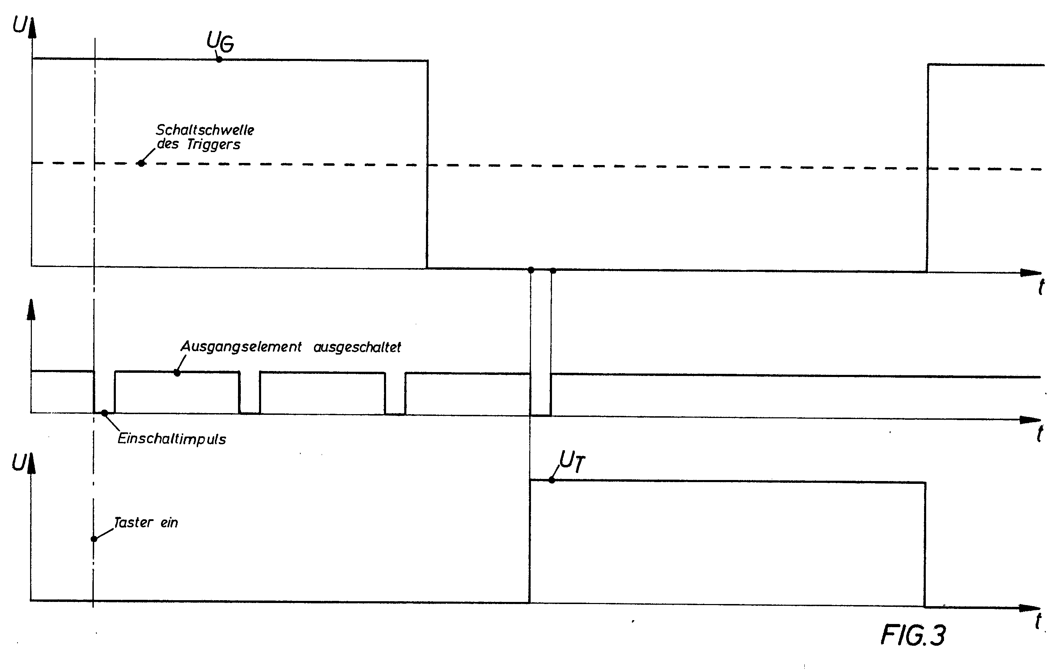

Erfindungsgemäß wird diese Aufgabe durch die im kennzeichnenden Teil des Anspruches 1 beschriebenen Merkmale gelöst. Eine vorteilhafte Ausführungsform der Erfindung ist in dem Unteranspruch festgehalten. Gemäß einer ersten Ausbildung der Erfindung wird die Spannungsversorgung der Ausgangselemente für die Dauer des Prüfvorganges abgeschaltet (Fig. 1) und das im angesteuerten Lastkreis befindliche Ausgangselement nach Zuschaltung eines Rechteck-Generators mit der Rechteck-Spannung $U_G$ (Fig. 3) versorgt.

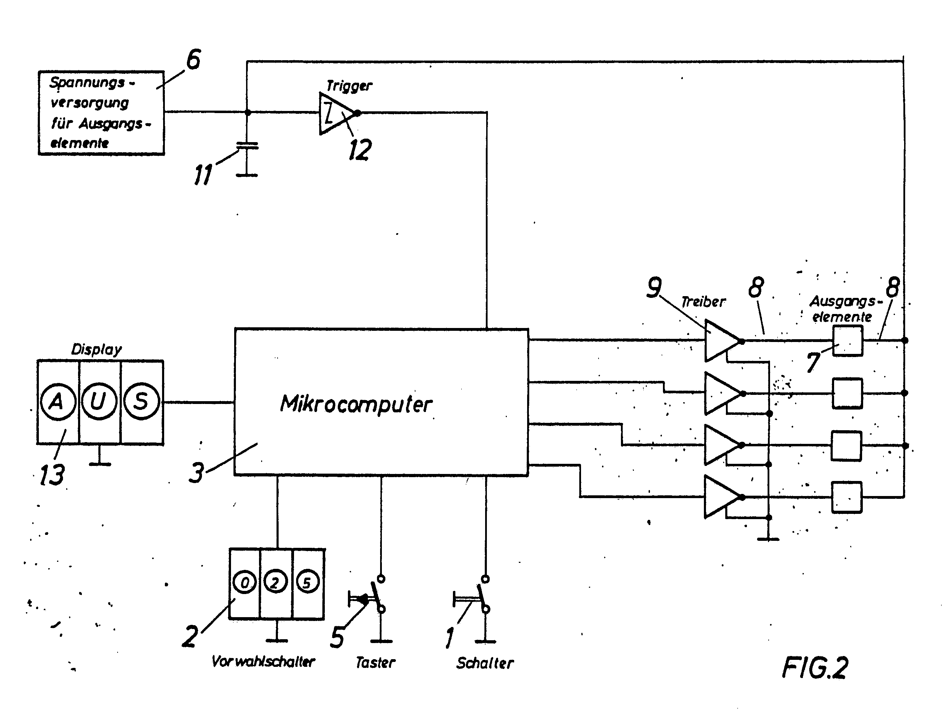

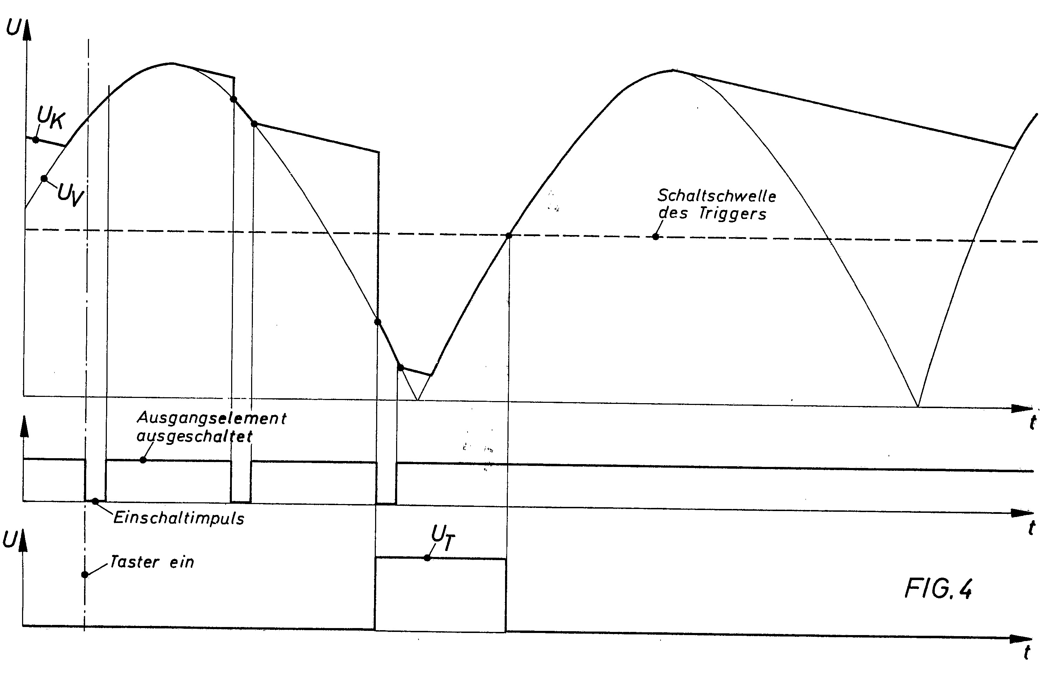

Eine weitere Ausbildung der Erfindung besteht darin, daß die Durchgangsprüfung eines mit ungeglätteter Gleichspannung $U_V$ (Fig. 4) versorgten Ausgangselementes einschließlich seiner Installation und seines Treibers direkt mit der ungeglätteten Gleichspannung $U_V$ vorgenommen wird (Fig. 2).

Mit der Erfindung werden folgende Vorteile erzielt:

1. Nach einem vorgegebenen Prüfprogramm kann jedes zur Steuerung der betriebsfertigen Maschine bzw. Anlage gehörende Ausgangselement zusammen mit seiner Installation und seinem Treiber angesteuert und anschließend auf Durchgang geprüft werden.

2. Für die Durchgangsprüfung werden mit Ausnahme einer einfachen Prüfleitung zur Überbrückung des Ausgangselementes (nur bei angelegter Rechteck-Spannung möglich) oder dessen Installation (bei angelegter Rechteck-Spannung wie auch bei angelegter, ungeglätteter Gleichspannung möglich) zwecks Fehlereinkreisung keine zusätzlichen Meßmittel und Anzeigegeräte benötigt.

3. Zur Durchführung der Durchgangsprüfung ist das Auftrennen einzelner Leitungsstränge in den Lastkreisen nicht erforderlich.

4. Die Durchgangsprüfung läßt den eindeutigen Rückschluß zu, ob der vorgeschaltete Treiber defekt ist oder nicht.

Anhand der in den Zeichnungen dargestellten Ausführungsbeispiele wird die Erfindung näher erläutert. Es zeigt

Fig. 1 ein Blockschaltbild, aus dem der prinzipielle Aufbau eines ersten Ausführungsbeispiels für die Durchführung der Durchgangsprüfung zu ersehen ist, wobei das Ausgangselement für die Dauer der Prüfung mit Rechteck-Spannung $U_G$ versorgt wird;

Fig. 2 ein Blockschaltbild, aus dem der prinzipielle Aufbau eines zweiten Ausführungsbeispiels für die Durchführung der Durchgangsprüfung zu ersehen ist, wobei das Ausgangselement mit ungeglätteter Gleichspannung $U_V$ versorgt wird;

Fig. 3 zwei Spannungs-Zeit-Diagramme, aus denen der zeitliche Ablauf der Rechteck-Spannung $U_G$ und der Trigger-Spannung $U_T$ nach Einleitung des Prüfvorganges zu ersehen ist;

Fig. 4 zwei Spannung-Zeit-Diagramme, aus denen der zeitliche Ablauf der ungeglätteten Gleichspannung $U_V$, der Kondensator-Spannung $U_K$ und der Trigger-Spannung $U_T$ nach Einleitung

des Prüfvorganges zu ersehen ist;

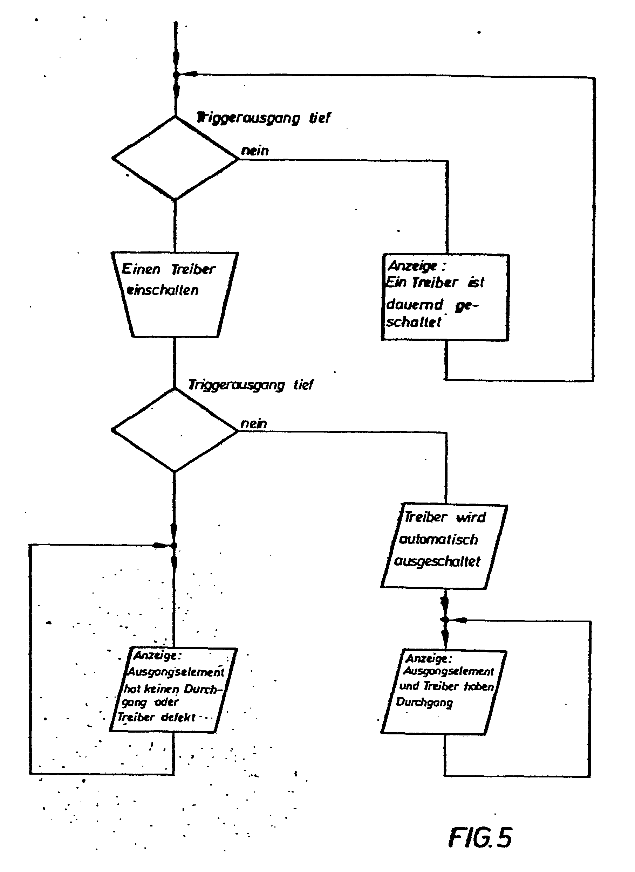

Fig. 5 ein Flußdiagramm, aus dem der Ablauf der rechnergestützten Durchgangsprüfung eines Ausgangselementes einschließlich seiner Installation und seines Treibers zu ersehen ist.

Mit der Bezugszahl 1 wird ein Schalter bezeichnet, mit dem die Maschinen-Steuerung auf das Prüfprogramm umgeschaltet wird. Für die Ansteuerung eines auf Durchgang zu prüfenden Lastkreises, bestehend aus einem Ausgangselement einschließlich seiner Installation und seines vorgeschalteten Treibers, wird die betreffende Code-Nummer mit dem mehrstelligen Vorwahlschalter 2 eingestellt. Der Mikrocomputer 3 ermöglicht die Ansteuerung des jeweiligen Lastkreises.

Nach Betätigung des Umschalters 4 und Drücken des Tasters 5 wird der Prüfvorgang eingeleitet. Der sich jetzt in der Stellung »Prüfen« befindliche Umschalter 4 unterbricht die Verbindung von der Spannungsversorgung 6 zum angesteuerten Lastkreis, der aus dem Ausgangselement 7, der Installation 8 und dem Treiber 9 besteht und ermöglicht, daß das Ausgangselement 7 mit der vom Generator 10 erzeugten Rechteck-Spannung $U_G$ versorgt wird. Um zu verhindern, daß das mit Rechteck-Spannung $U_G$ versorgte Ausgangselement mechanisch reagieren kann, wird es bei gedrücktem Taster 5 nur kurzzeitig eingeschaltet. Die Zeitdauer des Einschaltimpulses, die kleiner ist als das Intervall »Ausgangselement ausgeschaltet«, wird vom Mikrocomputer 3 begrenzt. Zur Durchgangsprüfung wird die Überprüfung des Stromflusses im angesteuerten Lastkreis mittels der am Ausgang des Generators 10 befindlichen Meßschaltung durchgeführt, die aus dem Kondensator 11 mit relativ geringer Kapazität und dem Trigger 12 besteht. Der Kondensator 11 wird nach Betätigung des Umschalters 4 mittels der Rechteck-Spannung $U_G$ aufgeladen. Der Trigger 12 überwacht die Kondensator-Spannung $U_K$. Die Schaltschwelle des Triggers 12 ist auf einen Wert eingestellt, der etwa der halben Rechteck-Spannung $U_G$ entspricht.

Nach Betätigung des Schalters 1 und des Umschalters 4 kann die Kondensator-Spannung $U_K$ normalerweise nicht unter die Schaltschwelle des Triggers 12 absinken. Ist dies dennoch der Fall (Trigger-Spannung hoch), so folgt daraus, daß ein in der Steuerung befindlicher Treiber dauernd geschaltet ist oder daß ein Leitungsschluß vorliegt. Dieser Fehler muß zunächst behoben werden, bevor mit der eigentlichen Durchgangsprüfung begonnen werden kann. Sinkt die Kondensator-Spannung $U_K$ nach Zuschaltung eines Lastkreises unter die Schaltschwelle des Triggers 12 (Trigger-Spannung hoch), so ist dies ein Anzeichen dafür, daß im angesteuerten Lastkreis Strom fließt, d. h. er ist nicht unterbrochen. Auf dem Display 13 erscheint die Aussage »Ausgangselement und Treiber haben Durchgang«. Entlädt sich der Kondensator 11 nicht, d. h. seine Spannung $U_K$ liegt oberhalb der Schaltschwelle des Triggers 12, so bedeutet dies, daß im angesteuerten Lastkreis kein Strom fließt. Daraus folgt, daß ein Teil des angesteuerten Lastkreises keinen Durchgang hat. Zur weiteren Fehlereinkreisung können die hinter dem Treiber 9 befindliche, zum Ausgangselement 7 führende Installation 8 und das Ausgangselement 7 nacheinander mittels einer Prüfleitung überbrückt werden. Bei der Überbrückung des Ausgangselementes 7 tritt eine Überlastung des Treibers 9 wegen des Ausgangswiderstandes des Generators 10 nicht ein. Der Treiber selbst kann nicht direkt auf Durchgang geprüft werden. Die Aussage »Treiber hat keinen Durchgang« kann jedoch nach durchgeführter Überbrückung jedes anderen im Lastkreis befindlichen Teiles durch Rückschluß gewonnen werden. Das Ergebnis der Durchgangsprüfung wird auf dem Display 13 angezeigt. Zur Anzeige können jedoch auch Leuchtdioden oder Kontrollampen verwendet werden. Die Aussage »Ausgangselement und Treiber haben Durchgang« kann nur dann erlangt werden, wenn der Einschaltimpuls in die Niedrigphase der Rechteck-Spannung $U_G$ fällt. Aus Fig. 3 ist zu ersehen, daß in dem aufgezeichneten Beispiel erst der vierte Einschaltimpuls die zuvor genannte Voraussetzung antrifft. Danach wird der Prüfvorgang automatisch, selbst bei weiterhin gedrücktem Taster 5, beendet.

Eine weitere Ausbildung der Erfindung ist aus Fig. 2 zu ersehen. Diese Schaltungsanordnung für die Durchführung der Durchgangsprüfung kann verwendet werden, wenn die in der Steuerung befindlichen Ausgangselemente mit ungeglätteter Gleichspannung $U_V$ (Fig. 4) versorgt werden.

Aber auch bei deren Versorgung aus einer Quelle für geglättete Gleichspannung kann die Schaltungsanordnung nach Fig. 2 verwendet werden, vorausgesetzt, daß während der Dauer der Durchgangsprüfung die Glättungskondensatoren in der Spannungsversorgung 6 abgeschaltet sind. Die Schaltungsanordnung nach Fig. 2 unterscheidet sich im wesentlichen dadurch von der nach Fig. 1, daß die ungeglättete Gleichspannung $U_V$ für die Dauer der Durchgangsprüfung nicht abgeschaltet und durch eine andere Spannung ersetzt werden muß. Deshalb ist bei der Schaltungsanordnung nach Fig. 2 weder der in Fig. 1 gezeigte Umschalter 4 noch der Generator 10 erforderlich. Während des Prüfvorganges wird das im angesteuerten Lastkreis befindliche Ausgangselement 7 mit ungeglätteter (ggf. nach vorheriger Abschaltung der Glättungskondensatoren) Gleichspannung $U_V$ versorgt, die durch die Spannungsversorgung 6 erzeugt wird. Die Kondensator-Spannung $U_K$ des aufgeladenen Kondensators 11 wird vom Trigger 12 überwacht. Die Schaltschwelle des Triggers 12 ist auf einen Wert eingestellt, der etwa dem halben Spitzenwert der ungeglätteten Gleichspannung $U_V$ entspricht. Nach Betätigung des Schalters 1 sowie nach Adresseneingabe des zu prüfenden Ausgangselementes 7 einschließlich seiner Installation 8 und seines Treibers 9 in den Vorwahlschalter 2 und dem Drücken des Tasters 5 wird der Prüfvorgang eingeleitet. Sinkt die Kondensator-Spannung $U_K$ unter die Schaltschwelle des Triggers 12, so verursacht die jetzt hohe Trigger-Spannung auf dem Display 13 die Anzeige »Ausgangselement und Treiber haben Durchgang«. Sinkt die Kondensator-Spannung $U_K$ bei zugeschaltetem Ausgangselement samt Treiber nicht unter die Schaltschwelle des Triggers 12, ist das ein Anzeichen dafür, daß der angesteuerte Lastkreis keinen Durchgang hat. Zur Fehlereinkreisung kann die Installation 8 mittels einer Prüfleitung überbrückt werden. Um jedoch eine Überlastung des Treibers 9 zu verhindern, darf bei der Schaltungsanordnung nach Fig. 2 das Ausgangselement 7 nicht überbrückt werden. Zur eindeutigen Aussage, ob das betreffende Ausgangselement defekt ist, muß es in diesem Fall gegen ein funktionstüchtiges ausgetauscht werden. Haben das Ausgangselement 7 und seine Installation 8 Durchgang, so kann sich die Unterbrechung nur im Treiber 9 befinden. Die Aussage »Ausgangselement und Treiber haben Durchgang« kann nur erlangt werden, wenn der Einschaltimpuls in die Phase fällt, in der sich die ungeglättete Gleichspannung $U_V$ unterhalb der Schaltschwelle des Triggers 12 befindet. Aus Fig. 4 ist zu ersehen, daß in dem aufgezeichneten Beispiel erst der dritte Einschaltimpuls die zuvor genannte Voraussetzung antrifft. Danach wird der Prüfvorgang automatisch, selbst bei weiterhin gedrücktem Taster 5, beendet.

Die erfindungsgemäße Schaltungsanordnung zur rechnergestützten Durchgangsprüfung zu deren Durchführung keine zusätzlichen, nicht bereits in der betreffenden Steuerung enthaltenen Meß- und Anzeigemittel erforderlich sind, vereinfacht die Reparaturarbeiten an komplizierten Steuerungen, die an der Schnittstelle zwischen der Mechanik, der Pneumatik oder Hydraulik und der Elektrik angesiedelt sind.

**Patentansprüche**

1. Schaltungsanordnung zur mit Gleichspannung durchführbaren Funktionsprüfung mehrerer in einer Steuerung enthaltener, nacheinander zu prüfender Treiber, wobei am Ausgang jedes Treibers zur Überprüfung seines Schaltzustandes durch Überwachung der am Treiberausgang anliegenden Spannung ein einen Trigger aufweisender Schaltkreis vorgesehen ist und die Schaltungsanordnung so ausgelegt ist, daß die Einschaltimpulse zur Funktionsprüfung so kurz bemessen sind, daß dem jeweils angewählten Treiber nachgeschaltete Funktionseinheiten nicht geschaltet werden, dadurch gekennzeichnet, daß aus der Anzahl der in der Steuerung enthaltenen Lastkreise, die jeweils aus einem Ausgangselement (7) einschließlich seiner Installation (8) und seinem vorgeschalteten Treiber (9) bestehen, nach Einleitung des Prüfvorganges ein einzelner Lastkreis durch kurzzeitige, von einem Mikrocomputer (3) zeitlich begrenzte Einschaltimpulse zur Durchgangsprüfung angesteuert wird, daß eine für die Durchgangsprüfung sämtlicher Lastkreise zuständige aus einem Kondensator (11) und dem Trigger (12) bestehende zentrale Meßschaltung die Überprüfung des Stromflusses in dem mit Rechteck-Spannung ($U_G$) bzw. mit aus Sinus-Halbwellen zusammengesetzter, ungeglätteter Gleichspannung ($U_V$) versorgten, auf Durchgang zu prüfenden Lastkreis ermöglicht und daß der Mikrocomputer (3) bei Abfrage der zentralen Meßschaltung während der Einschaltimpulse nur dann zu der Aussage »Durchgang« gelangt, wenn die impulsförmige Rechteck-Spannung ($U_G$) bzw. die ungeglättere Gleichspannung ($U_V$) unter die Schaltschwelle des Triggers (12) abgesunken ist.

2. Schaltungsanordnung nach Anspruch 1, dadurch gekennzeichnet, daß die Schaltschwelle des Triggers (12) auf einen Wert eingestellt ist, der etwa dem halben Maximalwert der Rechteck-Spannung ($U_G$) bzw. etwa dem halben Spitzenwert der ungeglätteten Gleichspannung ($U_V$) entspricht.

**Claims**

1. Circuitry for functional checking of a plurality of drivers to be accomplished by a DC voltage, said drivers are incorporated in a control unit and are to be checked successively; in which circuitry at the output of each driver one circuit incorporating a trigger is provided for the purpose of checking the circuit condition of each selected driver by monitoring the voltage applied to the output of it and that the circuitry is constructed such, that the duration of the activating pulses for initiating the functional checking is dimensioned to such a short duration, that the functional units following each selected driver will not be avtivated, characterised in that from a plurality of load circuits incorporated in the control unit — each of said load circuits comprising one actuator element (7) including its installation (8) and its preceding driver (9) — an individual load circuit is triggered after the checking procedure was initiated by means of short-time activating pulses for continuity checking, the duration of said pulses is limited by means of a micro-computer (3) and that a measuring circuit, which is competent for the continuity checking of all load circuits is provided, incorporating a condenser (11) and the trigger (12), which measuring circuit enables the checking of the current passage in the load circuit selected for checking for continuity, which load circuit is supplied with a rectangular voltage ($U_G$) or an unsmoothened DC voltage ($U_V$), composed of sinusoidal half waves respectively, and that the micro-computer (3) will come to the result »continuity«, whilst the central measuring circuit is interrogated during the action of the activating pulses, only under the provision, that the rectangular voltage ($U_G$) in the form of pulses or the unsmoothened DC voltage ($U_V$) respectively, has dropped below the threshold level of the trigger (12).

2. Circuitry as per claim 1, characterized in that the threshold level of the trigger (12) is set to a value, which is equivalent to approximately a half of the maximum value of the rectangular voltage ($U_G$) or to approximately a half of the peak value of the unsmoothened DC voltage ($U_V$).

## Revendications

1. Circuit pour essayer la fonction de plusieurs circuits d'exitation, exécutable d'une voltage continue, quelles circuits sont contenus dans un système de contrôle et doivent être essayé successivement; où à la sortie de quaque circuit d'exitation un circuit muni d'un trigger est prévu, en vue d'examiner son état de communication à l'aide de la surveillance de la voltage vive à la sortie du circuit d'exitation et que le circuit pour essayer est construit de telle manière, que les impulsions d'attaque pour actionner l'essai de la fonction sont dimensionnés de telle courte durée, que les unités fonctionelles intercalés en arrière du circuit d'exitation selectionné ne sont mettre en circuit, caracterisé ence que d'une quantité de circuits de charge contenue dans le système de contrôle — chaque circuit est composé d'un élement de sortie (7) inclusivement son installation (8) et son circuit d'exitation intercalé (9) — un circuit de charge particulier est actionné après l'introduction du procédé d'essai par des impulsations d'attaque, dimesionnés de courte durée par un micro-calculateur (3), et qu'un circuit de mésure central est prévu, qui est compétent pour l'épreuve de continuité de tous les circuits de charge — se composant d'un condensateur (11) et un trigger (12), quelle circuit de mésure rend possible le contrôle de la continuité de courant du circuit de charge, qui est alimenté d'une voltage d'impulsions rectangulaires ($U_G$) respectivement d'une voltage continue non filtrée ($U_V$), composée de demi-ondes sinusoïdals et que le micro-calculateur (3) attaindra au résultat »Continuité« au cas où la voltage d'impulsions regtangulaires ($U_V$) respectivement la voltage continue ($U_V$) non filtrée est reláchée sous la valeur de seuil du trigger (12).

2. Circuit pour essayer selon 1, caractérisé en ce que la valeur de seuil du trigger (12) est ajustée à une valeur correspondent approximativement à moitié de la voltage rectangulaire ($U_G$) respectivement approximativement à moitié de la valeur de crête de la voltage continue non filtrée ($U_V$).

FIG.1

FIG.2

FIG.3

$U_G$

Schaltschwelle
des Triggers

Ausgangselement ausgeschaltet

Einschaltimpuls

$U_T$

Taster ein

0 025 181

Schaltschwelle des Triggers

$U_K$

$U_V$

$U$

$t$

$U$

Ausgangselement ausgeschaltet

$U_T$

$t$

Einschaltimpuls

$U$

Taster ein

$t$

FIG. 4

Triggerausgang tief

nein

Einen Treiber
einschalten

Anzeige :
Ein Treiber ist
dauernd geschaltet

Triggerausgang tief

nein

Treiber wird
automatisch
ausgeschaltet

Anzeige:
Ausgangselement
hat keinen Durchgang oder
Treiber defekt

Anzeige:
Ausgangselement
und Treiber haben
Durchgang

FIG. 5